Europäisches Patentamt

European Patent Office

Office européen des brevets

(19)

(11) Veröffentlichungsnummer: **0 051 299**
**B1**

(12) **EUROPÄISCHE PATENTSCHRIFT**

(45) Veröffentlichungstag der Patentschrift:
06.06.84

(21) Anmeldenummer: 81109330.1

(22) Anmeldetag: 30.10.81

(51) Int. Cl.³: **B 60 Q 11/00**, G 01 R 19/165

(54) **Prüfschaltung, insbesondere in Kraftfahrzeugen.**

(30) Priorität: 03.11.80 DE 3041206

(43) Veröffentlichungstag der Anmeldung:
12.05.82 Patentblatt 82/19

(45) Bekanntmachung des Hinweises auf die Patenterteilung:
06.06.84 Patentblatt 84/23

(84) Benannte Vertragsstaaten:
FR GB IT

(56) Entgegenhaltungen:
DE - A - 2 700 995
FR - A - 2 228 255
GB - A - 2 032 155
US - A - 4 195 281

(73) Patentinhaber: Kabelwerke Reinshagen GmbH,
Reinshagenstrasse 1, D-5600 Wuppertal 21 (DE)

(72) Erfinder: Gündel, Manfred, Ing. grad., Zillertaler
Strasse 33a, D-5600 Wuppertal 12 (DE)
Erfinder: Schlamm, Heinz-Werner, Dipl.-Ing.,
Reuterstrasse 22, D-5600 Wuppertal 11 (DE)
Erfinder: Schmitz, Klaus-Dieter, Augustastrasse 87,
D-5600 Wuppertal 1 (DE)

(74) Vertreter: Priebisch, Rüdiger, Kabelwerke Reinshagen
GmbH Patentabteilung Reinshagenstrasse 1,
D-5600 Wuppertal 21 (DE)

**Beschreibung**

Die Erfindung betrifft eine Prüfschaltung zum Erkennen von Unterbrechungen in elektrischen Verbraucherstromkreisen, bei der im Falle einer Unterbrechung im Verbraucherstromkreis eine Anzeigevorrichtung schaltbar ist, sowie ihre Verwendung in Kraftfahrzeugen.

Es sind schon Prüfschaltungen bekannt, bei denen im Verbraucherstromkreis ein Widerstand (Vorwiderstand) geschaltet ist. Der Spannungsabfall an diesen Widerständen dient als Maß für die Kontrolle des Verbraucherstromkreises, vergl. die veröffentlichte deutsche Patentanmeldung DE-A-2 147 681. Ein solcher Spannungsabfall ist jedoch in der Regel unerwünscht. Wird er durch Wahl von kleinen Widerstandswerten gering gehalten, so erfordert dies einen größeren Schaltungsaufwand für die Auswertung. Zum zweiten ist eine Überprüfung des Verbraucherstromkreises nur in eingeschaltetem Zustand möglich, man spricht hier von sogenannter Warmabfrage. In nicht eingeschaltetem Zustand ist ein Fehler in dem zu überwachenden Verbraucherstromkreis nicht erkennbar.

Dieser Nachteil wurde schon bekannt. So wurde in der veröffentlichten deutschen Patentanmeldung DE-A-2 363 091 vorgeschlagen, durch eine besondere Schaltungsanordnung zu ermöglichen, eine defekte Bremslampe bei Kraftfahrzeugen schon bei Antritt einer Fahrt, d. h. bei Nichtbenutzung der Bremsanlage, festzustellen. Diese Schaltungsanordnung ist jedoch nur bei zwei parallel geschalteten Verbrauchern anwendbar, wie dies z. B. bei Bremslampen von Kraftfahrzeugen der Fall ist. Zudem zeigen diese vorgeschlagenen Schaltungen nur Fehler an, die vor dem Fahrtantritt, d. h. vor der ersten Bremsbetätigung vorhanden sind, man spricht hier von sogenannter Kaltabfrage.

In der veröffentlichten deutschen Patentanmeldung DE-A-2 906 878 ist schon die Verwendung eines Reed-Schalters zur Steuerung einer Überwachungsleuchte gezeigt. Auch bei dieser Schaltungsanordnung ist nur eine Warmabfrage möglich.

Der Erfindung liegt die Aufgabe zugrunde, eine Schaltungsanordnung zu schaffen, die einen Verbraucherstromkreis sowohl im ausgeschalteten als auch im eingeschalteten Zustand überwacht, d. h. Fehler selbsttätig und unabhängig vom augenblicklichen Betriebszustand des Verbraucherstromkreises anzeigt.

Diese Aufgabe wird bei einer Prüfschaltung zum Erkennen von Unterbrechungen in elektrischen Verbraucherstromkreisen, bei der im Falle einer Unterbrechung im Verbraucherstromkreis eine Anzeigevorrichtung schaltbar ist, dadurch gelöst, daß eine an der Versorgungsspannung liegende Auswert- und Anzeigestufe einen Anschlußpunkt aufweist, bei dessen Anschluß an Masse die Anzeigevorrichtung geschaltet wird, und daß von diesem Anschlußpunkt über eine Prüfstufe zwei alternative Verbindungen zur Masse führen, wobei die erste Verbindung über einen Schalter erfolgt, der vom Verbraucherstrom so betätigt wird, daß er nur bei eingeschaltetem und ordnungsgemäßen Verbraucherstromkreis geschlossen ist, und wobei die zweite Verbindung über ein Bauelement erfolgt, das bei abgeschaltetem Verbraucherstromkreis den Anschlußpunkt über die nach dem Verbraucherschalter liegenden Bauteile des Verbraucherstromkreises mit Masse verbindet.

Das die zweite Verbindung herstellende Bauteil kann eine Diode sein, die in Durchlaßrichtung vom Anschlußpunkt zum Verbraucherstromkreis hin geschaltet ist. Als Schalter ist vorzugsweise ein vom Verbraucherstrom induktiv betätigter Schutzrohrschalter verwendet. Im letzten Falle kann das die zweite Verbindung herstellende Bauelement ein in den Schalter integrierter Ruhekontakt (Umschaltkontakt) sein. In allen vorgenannten Fällen kann die Auswert- und Anzeigestufe eine von einem Transistor geschaltete Leuchtdiode umfassen. Bei der Verwendung eines Umschaltkontaktes kann zudem die Auswert- und Anzeigestufe vereinfacht aufgebaut sein. Besonders vorteilhaft ist die Verwendung der Prüfschaltung zum Erkennen von Fehlern in Lampenstromkreisen in Kraftfahrzeugen.

Die Erfindung ermöglicht die Überprüfung eines Stromkreises zu jeder Zeit, d. h. unabhängig davon, ob er ein- oder ausgeschaltet ist. Bei der Verwendung zum Erkennen von Fehlern in Lampenstromkreisen in Kraftfahrzeugen kann sowohl bei Fahrtbeginn — z. B. bei der Einschaltung der Zündung — als auch während der Fahrt — z. B. nach Einschalten der Fahrzeugbeleuchtung — die Funktionsfähigkeit der Lampen lückenlos, d. h. zu jeder Zeit, und selbsttätig, d. h. ohne Zutun des Fahrers, überwacht und angezeigt werden.

In der Zeichnung sind zwei Ausführungsbeispiele der Erfindung dargestellt, die im folgenden näher beschrieben werden.

Fig. 1 zeigt eine Prüfschaltung zur Überwachung eines Lampenstromkreises mit einer eine Transistor geschaltete LED umfassende Auswert- und Anzeigestufe, die mit Hilfe eines einpoligen Relais und einer Diode geschaltet wird.

Fig. 2 zeigt eine Prüfschaltung gemäß Fig. 1, bei der die nicht gezeigte Auswert- und Anzeigestufe mittels eines zweipoligen Relais geschaltet wird.

Die Prüfschaltung umfaßt eine Auswert- und Anzeigestufe 1, die einerseits mit der Klemme +15 eines Kraftfahrzeuges, d. h. z. B. an der Zündspannung von ca. 13 Volt, und andererseits mit Masse, d. h. z. B. mit Minus, verbunden ist. Als Anzeigevorrichtung dient eine Leuchtdiode (= LED) 2. Mit $R_1$ bis $R_4$ sind geeignete Widerstände bezeichnet. Widerstand $R_1$ dient als Vorwiderstand zur Strombegrenzung, die Widerstände $R_2$ bis $R_4$ bilden einen Spannungsteiler, an dem zwischen den Widerständen $R_3$ und $R_4$ die Basisspannung für einen Schalttransistor 3 abgegriffen wird. Zwischen den Widerständen $R_2$

und R₃ ist der Eingangspunkt E angeordnet, an den der Ausgangspunkt A der Prüfstelle 4 angeschlossen wird.

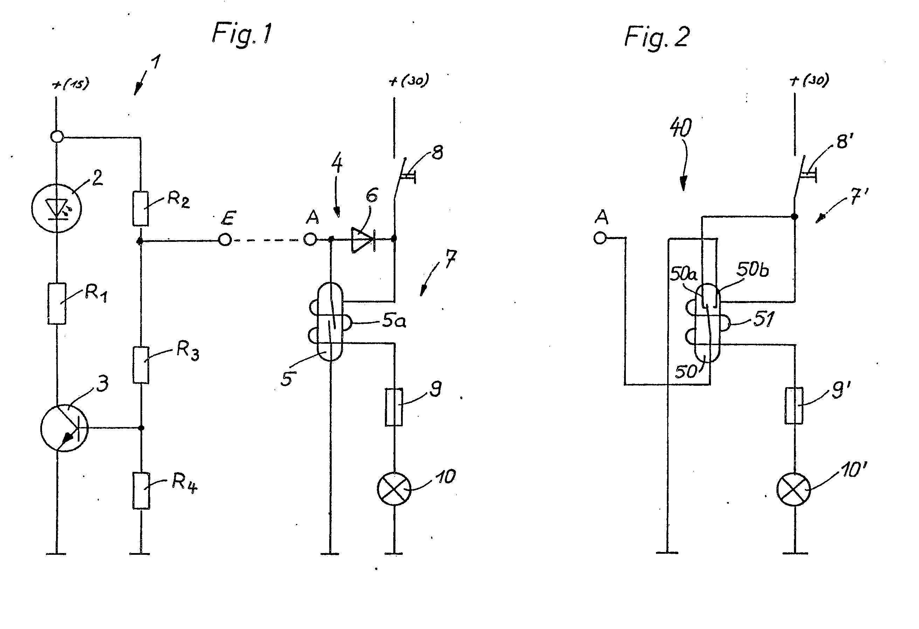

Die Prüfstufe 4 (Fig. 1) umfaßt einen Reed-Kontakt 5, der zur Masse führt, und eine Diode 6, die in Durchlaßrichtung vom Anschlußpunkt A zum Verbraucherstromkreis 7 geschaltet ist, und zwar unmittelbar nach dem Verbraucherschalter 8. Der Verbraucherstromkreis 7 ist einerseits an die Klemme +30, d. h. an die Batteriespannung von ca. +13 Volt, und andererseits an Masse, d. h. hier an Minus, angeschlossen. Dem Verbraucherschalter 8 ist eine Spule 5a zur Betätigung des Reed-Kontaktes 5, eine Sicherung 9 für den Verbraucher und als Verbraucher eine Glühlampe 10 nachgeschaltet. Dieser Verbraucherstromkreis 7 stellt einen Verbraucherstromkreis in vereinfachter Form dar.

In Fig. 2 ist eine Variante 40 der Prüfstufe 4 gezeigt. Hier ist ein Reed-Schalter 50 mit Ruhekontakt 50a zum Verbraucherstromkreis 7 und mit einem Umschaltkontakt 50b zur Masse angeordnet. Hier wurde also anstelle einer Diode (siehe Fig. 1) der Ruhekontakt 50a vorgesehen.

Die Funktion der Schaltung zu Fig. 1 ist folgende:

Wird im Kraftfahrzeug die Zündung eingeschaltet, so liegt an der Klemme +15 Betriebsspannung an. Zum Durchschalten des Transistors 3, d. h. zum Einschalten der LED 2, ist es erforderlich, daß an der Basis des Transistors, d. h. nach dem Widerstand R₃, eine Spannung von ca. 0,7 Volt anliegt. Dies ist aber nur dann der Fall, wenn am Punkt E keine Masse anliegt. Masse liegt jedoch infolge der Prüfstufe 4 (bzw. 40 in Fig. 2) immer dann an, wenn der überprüfte Verbraucherstromkreis 7 (7' in Fig. 2) in Ordnung ist, d. h. keine Unterbrechung aufweist.

Fall 1:
Lampe 10 ist ausgeschaltet (Kaltabfrage).
Unter-Fall 1a:
Der Verbraucherstromkreis 7 ist in Ordnung: Das Massepotential wird über die Lampe 10, die Sicherung 9, die Spule 5a und die Diode 6 dem Punkt A zugeführt. Die Durchlaßspannung der Diode 6 von ca. 0,7 Volt wird am Spannungsteiler der Widerstände R₃ und R₄ aufgeteilt, so daß an der Basis des Transistors 3 mit Sicherheit keine 0,7 Volt anliegen und somit ein Einschalten der LED 2 unmöglich ist: Die Warnanzeige wird nicht eingeschaltet.
Unter-Fall 1b:
Der Verbraucherstromkreis ist defekt: In diesem Fall kann über den unterbrochenen Verbraucherstromkreis 7 keine Masse an den Punkt A herangeführt werden: Die Warnanzeige, LED 2, wird eingeschaltet.
Fall 2:
Lampe 10 ist eingeschaltet (Warmabfrage).
Unter-Fall 2a:
Der Verbraucherstromkreis 7 ist in Ordnung: In diesem Falle wird durch die Spule 5a der Reed-Kontakt 5 geschlossen und Masse über den Reed-Kontakt 5 zum Punkt A geführt: Die Warnanzeige LED 2 wird nicht eingeschaltet.
Unter-Fall 2b:
Der Verbraucherstromkreis 7 ist defekt: Da die Spule 5a mangels Stromflusses im Verbraucherstromkreis 7 den Reed-Kontakt 5 nicht schließen kann, ist dieser geöffnet. Da der Verbraucherstromkreis 7 selbst unterbrochen ist, kann also weder über ihn noch über den Reed-Kontakt 5 Masse an den Punkt A geführt werden, d. h. der Transistor 3 schaltet durch und die Warnanzeige LED 2 wird eingeschaltet.

In Fig. 2 ist der gleiche Verbraucherstromkreis wie in Fig. 1 gezeigt, jedoch eine Variante der Prüfstufe, die hier mit 40 bezeichnet ist.

Die Funktion der Prüfstelle in Fig. 2 ist folgende:

Fall 1:
Lampe 10' ist ausgeschaltet (Kaltabfrage).
Unter-Fall 1a:
Der Verbraucherstromkreis 7' ist in Ordnung:
Das Massepotential wird über die Lampe 10' die Sicherung 9' die Spule 51 und den Ruhekontakt 50a über den Reed-Kontakt 50 an den Punkt A geführt: Die Warnanzeige (vergl. Fig. 1) wird nicht eingeschaltet.
Unter-Fall 1b:
Der Verbraucherstromkreis 7' ist nicht in Ordnung.
Da der Verbraucherstromkreis 7' unterbrochen ist, wird an den Punkt A keine Masse herangeführt: Die Warnanzeige wird eingeschaltet.
Fall 2:
Lampe 10' ist eingeschaltet (Warmabfrage):
Unter-Fall 2a:
Der Verbraucherstromkreis 7' ist in Ordnung:
Durch die vom Verbraucherstrom durchflossene Spule 51 wird der Reed-Kontakt 50 mit dem Arbeitskontakt 50b verbunden, so daß über diesen Masse an den Punkt A geführt wird. Die Warnanzeige wird nicht eingeschaltet.
Unter-Fall 2b:
Der Verbraucherstromkreis 7' ist nicht in Ordnung:
Da die Spule 51 den Arbeitskontakt 50b nicht schließen kann, wird weder über ihn noch über den unterbrochenen Verbraucherstromkreis 7' Masse an den Punkt A geführt: Die Warnanzeige wird eingeschaltet.

Für die Erfindung ist es unwesentlich, ob nun die Anzeigevorrichtung an- oder ausgeschaltet werden soll und wie die Anzeige, optisch oder akustisch, erfolgen soll. Desgleichen kann die Erfindung im Rahmen des fachmännischen Könnens schaltungstechnisch auch so aufgebaut werden, daß Minus an Klemme 15 bzw. 30 und Plus an Masse liegt, wie dies in der Praxis bei der Kfz-Verdrahtung in verschiedenen Ländern der Fall ist.

## Patentansprüche

1. Prüfschaltung zum Erkennen von Unterbrechungen in elektrischen Verbraucherstromkreisen, bei der im Falle einer Unterbrechung im Verbraucherstromkreis (7, 7') eine Anzeigevorrichtung (2) schaltbar ist, dadurch gekennzeichnet,

a) daß eine an der Versorgungsspannung liegende Auswert- und Anzeigestufe (1) einen Anschlußpunkt (E) aufweist, bei dessen Anschluß an Masse die Anzeigevorrichtung (2) geschaltet wird,

b) daß von diesem Anschlußpunkt (E) über eine Prüfstelle (4, 40) zwei alternative Verbindungen zur Masse führen,

c) wobei die erste Verbindung über einen Schalter (5, 50b) erfolgt, der vom Verbraucherstrom so betätigt wird, daß er nur bei eingeschaltetem und ordnungsgemäßen Verbraucherstromkreis (7, 7') geschlossen ist, und

d) wobei die zweite Verbindung über ein Bauelement (6, 50a) erfolgt, das bei abgeschaltetem Verbraucherstromkreis (7, 7') den Anschlußpunkt (E) über die nach dem Verbraucherschalter (8, 8') liegenden Bauteile (5a, 51; 9, 9'; 10, 10') des Verbraucherstromkreises (7, 7') mit Masse verbindet.

2. Prüfschaltung nach Anspruch 1, dadurch gekennzeichnet, daß das Bauelement eine Diode (2) ist, die in Durchlaßrichtung vom Anschlußpunkt (A) zum Verbraucherstromkreis (7, 7') hin geschaltet ist.

3. Prüfschaltung nach Anspruch 1 oder 2, dadurch gekennzeichnet, daß der Schalter (5, 50) ein vom Verbraucherstrom induktiv betätigter Schutzrohrschalter ist.

4. Prüfschaltung nach den Ansprüchen 1 und 3, dadurch gekennzeichnet, daß das Bauelement ein in den Schalter (50) integrierter Ruhekontakt (50a) ist.

5. Prüfschaltung nach einem der Ansprüche 1 bis 4, dadurch gekennzeichnet, daß die Auswert- und Anzeigestufe (1) eine von einem Transistor (3) geschaltete Leuchtdiode (2) umfaßt.

6. Prüfschaltung nach einem der Ansprüche 1 bis 5, gekennzeichnet durch ihre Verwendung zum Erkennen von Fehlern in Lampenstromkreisen in Kraftfahrzeugen.

## Claims

1. A control circuit for detecting interruptions in electric load circuits, in which an indicating device (2) can be switched on if there is an interruption in the load circuit (7, 7'), characterized

a) in that an evaluating and indicating stage (1) at the supply voltage has a connection point (E), on whose connection to earth the indicating device (2) is switched on,

b) in that from this connection point (E), two alternative connections lead to earth by way of a test stage (4, 40),

c) the first connection being made by way of a switch (5, 50b) which is actuated by the load current in such a way that it is only closed when the load circuit (7, 7') is switched on and in order, and

d) the second connection being made by way of a component (6, 50a) which, when the load circuit (7, 7') is switched off, connects the connection point (E) to earth by way of the components (5a, 51; 9, 9'; 10, 10') of the load circuit (7, 7') that are disposed downstream of the load switch (8, 8').

2. A control circuit according to claim 1, characterized in that the component is a diode (2), which is connected in the direction of conduction from the connection point (A) to the load circuit (7, 7').

3. A control circuit according to claim 1 or 2, characterized in that the switch (5, 50) is a protective-envelope switch inductively actuated by the load current.

4. A control circuit according to claims 1 and 3, characterized in that the said component is a stationary contact (50a) integrated in the switch (50).

5. A control circuit according to one of claim 1 to 4, characterized in that the evaluating and indicating stage (1) comprises a light-emitting diode (2) switched on by a transistor (3).

6. A control circuit according to one of claims 1 to 5, characterized by its use for detecting errors in lamp circuits in motor vehicles.

## Revendications

1. Circuit de contrôle pour détecter des interruptions dans des circuits électriques de courant de consommation, dans lequel un dispositif d'affichage (2) peut être enclenché dans le cas d'une interruption dans le circuit de courant de consommation (7, 7'), caractérisé par le fait

a) qu'un étage (1) d'interprétation et d'affichage, auquel est appliquée la tension d'alimentation, présente un point de raccordement (E) dont la jonction à la masse provoque l'enclenchement du dispositif d'affichage (2),

b) que, par l'intermédiaire d'un étage de vérification (4, 40), deux liaisons alternatives partent de ce point de raccordement (E) pour rejoindre la masse,

c) la première liaison étant assurée par l'intermédiaire d'un interrupteur (5, 50b) qui est actionné, par le courant de consommation, de telle sorte qu'il soit fermé seulement lorsque le circuit de courant de consommation (7, 7') est enclenché et est conforme, et

d) la seconde liaison étant assurée par l'intermédiaire d'un composant (6, 50a) qui, lorsque le circuit de courant de consommation (7, 7') est déclenché, relie à la masse le point de raccordement (E) par l'entremise des composants (5a, 51; 9, 9'; 10, 10') du circuit de courant de consommation (7, 7') situés après l'interrupteur (8, 8') du consommateur.

2. Circuit de contrôle selon la revendication 1, caractérisé par le fait que le composant est une diode (2) qui est branchée, dans la direction de la conduction, du point de raccordement (A) vers le circuit de courant de consommation (7, 7').

3. Circuit de contrôle selon la revendication 1 ou 2, caractérisé par le fait que l'interrupteur (5, 50) est un interrupteur à tube protecteur actionné inductivement par le courant de consommation.

4. Circuit de contrôle selon les revendications 1 et 3, caractérisé par le fait que le composant est un contact de repos (50a) incorporé dans l'interrupteur (50).

5. Circuit de contrôle selon l'une quelconque des revendication 1 à 4, caractérisé par le fait que l'étage (1) d'interprétation et d'affichage renferme une diode électroluminescente (2) enclenchée par un transistor (3).

6. Circuit de contrôle selon l'une quelconque des revendications 1 à 5, caractérisé par son utilisation pour détecter des défaillances dans des circuits électriques de lampes de véhicules automobiles.

Fig.1

Fig.2